# EUROPEAN PATENT APPLICATION

(11) **EP 4 752 586 A1**
(43) Date of publication of application: **03.06.2026**
(21) Application number: 25215280.6
(22) Date of filing: 12.11.2025
(51) Int. Cl.: G01R 33/483, G01R 33/565, G01R 33/54, G01R 33/56, G01R 33/567

(54) **MAGNETIC RESONANCE IMAGING APPARATUS, MAGNETIC RESONANCE IMAGING METHOD, AND MAGNETIC RESONANCE IMAGING PROGRAM**

(30) Priority: 29.11.2024 JP 2024208324
(71) Applicant: Canon Medical Systems Corporation, Tochigi 324-0036 (JP)
(72) Inventor: TAKESHIMA, Hidenori, Otawara-shi, 324-0036 (JP)
(74) Representative: Marks & Clerk LLP

(57) **Abstract**

A magnetic resonance imaging apparatus (100) according to an embodiment includes a prepulse application unit (121) configured to perform irradiation of a saturation RF pulse as a prepulse, a readout unit (122) configured to read out a saturation magnetic resonance signal in a spatially selective manner, the saturation magnetic resonance signal corresponding to a signal excited by the saturation RF pulse, a main-acquisition unit (123) configured to perform a main acquisition including irradiation of an excitation RF pulse, after the irradiation of the saturation RF pulse, the excitation RF pulse being a different RF pulse from the saturation RF pulse; and an output unit (124) configured to output the saturation magnetic resonance signal and main-acquisition data acquired by the main acquisition.

## Description

### FIELD

Embodiments described herein relate generally to a magnetic resonance imaging apparatus, a magnetic resonance imaging method, and a magnetic resonance imaging program.

### BACKGROUND

Conventionally, in the field of magnetic resonance imaging (MRI) the use of saturation prepulses is common for the purpose of suppression of unwanted magnetic resonance signals. Saturation prepulses refer to RF pulses to be applied to a subject prior to acquisition of diagnostic MR signals. For example, magnetic resonance spectroscopy (MRS) may use water-suppression prepulses as saturation prepulses. Other types of MRI may use fat suppression prepulses as saturation prepulses.

Such saturation prepulses are mainly non-slice selective pulses. In a non-slice selection, a spoiler is applied to the subject after a saturation prepulse. In other words, a saturation prepulse sequence is constituted of a combination of a non-slice selective saturation prepulse and a spoiler (gradient spoiler or RF spoiler). In the case of using outer volume suppression (OVS) pulses or sat band (saturation band) pulses as saturation prepulses, a saturation prepulse and a slice-select gradient field are applied together to the subject and then a spoiler is applied to the subject. Namely, this saturation prepulse sequence is constituted of a combination of a slice-select gradient field, a saturation prepulse, and a spoiler.

### SUMMARY OF THE INVENTION

A magnetic resonance imaging apparatus is provided, which includes a prepulse application unit configured to perform irradiation of a saturation RF pulse as a prepulse; a readout unit configured to read out a saturation magnetic resonance signal in a spatially selective manner, the saturation magnetic resonance signal corresponding to a signal excited by the saturation RF pulse; a main-acquisition unit configured to perform a main acquisition including irradiation of an excitation RF pulse, after the irradiation of the saturation RF pulse, the excitation RF pulse being a different RF pulse from the saturation RF pulse; and an output unit configured to output the saturation magnetic resonance signal and main-acquisition data acquired by the main acquisition.

The irradiation of the saturation RF pulse and the readout of the saturation magnetic resonance signal may be included in a pre-acquisition. The pre-acquisition may include application of a spoiler gradient that dephases the saturation magnetic resonance signal. The spoiler gradient may include a readout gradient field for the readout of the saturation magnetic resonance signal. The magnetic resonance imaging apparatus may further include a setting unit configured to set the spoiler gradient in such a manner that an integral of the spoiler gradient during an application duration of the spoiler gradient matches a design value set according to the main acquisition.

The readout gradient field may include either a gradient field or a multi-dimensional readout gradient field for adjustment of a readout start position of the saturation magnetic resonance signal.

The setting unit may set frequencies of the readout gradient field in accordance with a chemical shift. The readout unit may read out the saturation magnetic resonance signal by using the readout gradient field with the set frequencies.

The magnetic resonance imaging apparatus may further include an image generator unit configured to generate a first magnetic resonance image by applying a one-dimensional inverse Fourier transform to the saturation magnetic resonance signal in a readout direction of the saturation magnetic resonance signal, and generate a second magnetic resonance image by applying an inverse Fourier transform to the main-acquisition data; an inferring unit configured to infer motion of a subject irradiated with the saturation RF pulse from the first magnetic resonance image; and a corrector unit configured to perform a motion correction to the second magnetic resonance image based on the inference of the motion of the subject.

The magnetic resonance imaging apparatus may further include an image generator unit configured to generate a first magnetic resonance image by applying a one-dimensional inverse Fourier transform to the saturation magnetic resonance signal in a readout direction of the saturation magnetic resonance signal; and an inferring unit configured to infer a respiratory state of the subject irradiated with the saturation RF pulse from the first magnetic resonance image. The main-acquisition unit may perform the main acquisition in synchronization with respiration of the subject, based on the respiratory state of the subject.

The magnetic resonance imaging apparatus may further include a setting unit configured to set a first receiver gain for the readout of the saturation magnetic resonance signal, and set a second receiver gain for acquisition of the main-acquisition data. The first receiver gain and the second receiver gain may differ from each other.

The magnetic resonance imaging apparatus may further include a display unit that displays a selection screen that allows a selection of usage of the saturation magnetic resonance signal.

The display unit may display selection or non-selection of a navigator on the selection screen as an option for the usage.

A magnetic resonance imaging method is provided, which includes performing irradiation of a saturation RF pulse as a prepulse; reading out a saturation magnetic resonance signal in a spatially selective manner, the saturation magnetic resonance signal corresponding to a signal excited by the saturation RF pulse; performing a main acquisition including irradiation of an excitation RF pulse, after the irradiation of the saturation RF pulse, the excitation RF pulse being a different RF pulse from the saturation RF pulse; and outputting the saturation magnetic resonance signal and main-acquisition data acquired by the main acquisition.

A magnetic resonance imaging program is provided, which causes a computer to perform irradiation of a saturation RF pulse as a prepulse; read out a saturation magnetic resonance signal in a spatially selective manner, the saturation magnetic resonance signal corresponding to a signal excited by the saturation RF pulse; perform a main acquisition including irradiation of an excitation RF pulse, after the irradiation of the saturation RF pulse, the excitation RF pulse being a different RF pulse from the saturation RF pulse; and output the saturation magnetic resonance signal and main-acquisition data acquired by the main acquisition.

### BRIEF DESCRIPTION OF THE DRAWINGS

FIG. 1 is a schematic block diagram illustrating an exemplary configuration of a magnetic resonance imaging (MRI) apparatus according to one embodiment;
FIG. 2 illustrates an example of a pre-acquisition sequence according to one embodiment;
FIG. 3 illustrates an example of a gradient spoiler for saturation-MR-signal readout according to one embodiment;
FIG. 4 illustrates another example of a gradient spoiler different from the one in FIG. 3 according to one embodiment;
FIG. 5 illustrates an example of a pre-acquisition sequence PA including multiple saturation RF pulses according to one embodiment;
FIG. 6 illustrates a second MR image of a subject, a Z-directional first MR image, and a Y-directional first MR image according to one embodiment, as an example;
FIG. 7 illustrates a limited saturation region of saturation RF pulses and a second MR image of a subject P according to one embodiment, as an example;
FIG. 8 illustrates an example of a pre-acquisition sequence when an object being imaged is the liver;
FIG. 9 is a flowchart illustrating steps of a saturation-MR-signal utilization process according to one embodiment, as an example; and
FIG. 10 illustrates an example of a selection screen according to one embodiment.

### DETAILED DESCRIPTION

A magnetic resonance imaging apparatus according to one embodiment includes sequence control circuitry. The sequence control circuitry performs irradiation of a saturation RF pulse as a prepulse. The sequence control circuitry reads out a saturation magnetic resonance signal in a spatially selective manner, the saturation magnetic resonance signal corresponding to a signal excited by the saturation RF pulse. The sequence control circuitry performs a main acquisition including irradiation of an excitation RF pulse, after the irradiation of the saturation RF pulse. The excitation RF pulse is a different RF pulse from the saturation RF pulse. The sequence control circuitry outputs the saturation magnetic resonance signal and main-acquisition data acquired by the main acquisition.

Hereinafter, exemplary embodiments of a magnetic resonance imaging (MRI) apparatus, a magnetic resonance imaging method, and a magnetic resonance imaging program will be described in detail with reference to the accompanying drawings. In principle, descriptions and details of one embodiment are applicable to another embodiment. Throughout the following embodiments, parts, portions, elements, or functions denoted by the same reference numerals are considered to perform same or similar operations, and an overlapping explanation thereof will be omitted when appropriate.

### Embodiment

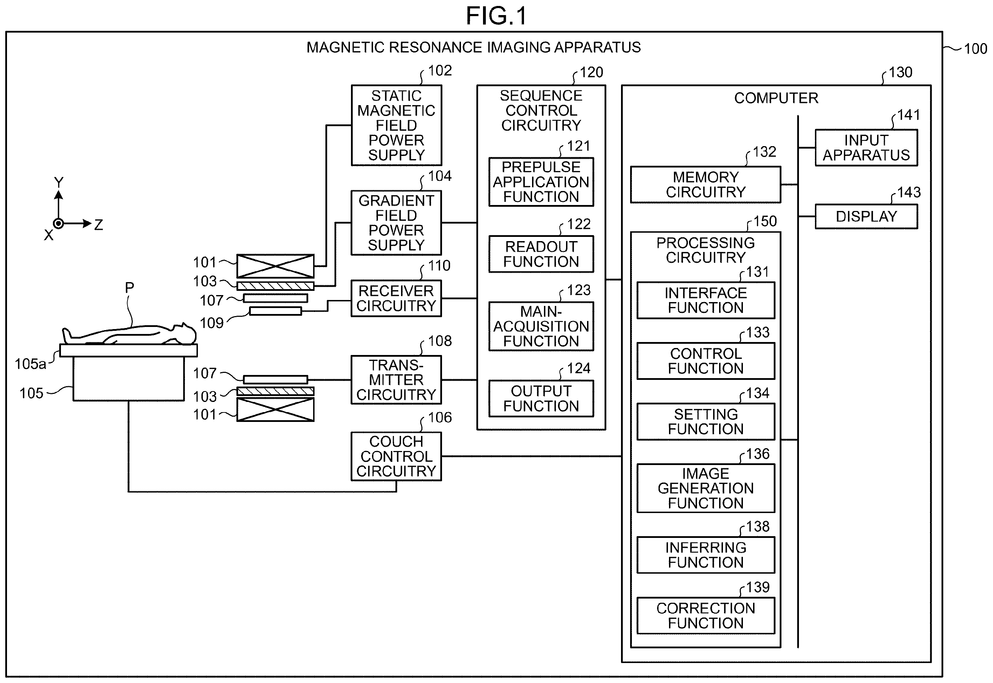

FIG. 1 is a schematic block diagram of an exemplary configuration of an MRI apparatus 100 according to one embodiment. As illustrated in FIG. 1, the MRI apparatus 100 includes static magnetic field magnets 101, a static magnetic field power supply 102, gradient coils 103, a gradient field power supply 104, a couch 105, couch control circuitry 106, transmitter coils 107, transmitter circuitry 108, a receiver coil 109, receiver circuitry 110, sequence control circuitry 120, and a computer (also referred to as image processing apparatus) 130. The MRI apparatus 100 does not include a subject P (such as a human body). The structure and configuration illustrated in FIG. 1 are merely exemplary. As an example, the respective elements of the sequence control circuitry 120 and the computer 130 may be integrated or separated when appropriate.

The static magnetic field magnets 101 are hollow, substantially cylindrical magnets to generate static magnetic fields in the internal space. Examples of the static magnetic field magnet 101 include a superconducting magnet that magnetizes, supplied with a current from the static magnetic field power supply 102. The static magnetic field power supply 102 supplies currents to the static magnetic field magnets 101. The static magnetic field magnets 101 can be permanent magnets. In this case the MRI apparatus 100 may not include the static magnetic field power supply 102. The static magnetic field power supply 102 may be separated from the MRI apparatus 100.

The gradient coils 103 have a hollow, substantially cylindrical shape and are located inside the static magnetic field magnets 101. Each gradient coil 103 is a combination of three coils corresponding to mutually orthogonal X-axis, Y-axis, and Z-axis. The three coils are individually supplied with currents from the gradient field power supply 104, to generate gradient fields that vary in field strength along the X, Y, and Z-axes, respectively. The gradient fields generated along the X, Y, and Z-axes by the gradient coils 103 are exemplified by a slice gradient field Gs, a phase-encoding gradient field Ge, and a readout gradient field Gr. The gradient field power supply 104 supplies currents to the gradient coils 103.

The couch 105 includes a couchtop 105a on which the subject P is to be laid. Under the control of the couch control circuitry 106, the couch 105 with the subject P lying thereon is inserted into a hollow space (imaging region) of the gradient coils 103. The couch 105 is typically installed in such a manner that its longitudinal side is parallel to the axes of the static magnetic field magnets 101. The couch control circuitry 106 drives the couch 105 to move the couchtop 105a longitudinally and vertically under the control of the computer 130.

The transmitter coils 107 are located inside the gradient coils 103, to generate high-frequency magnetic fields, supplied with RF pulses from the transmitter circuitry 108. The transmitter circuitry 108 supplies RF pulses corresponding to the Larmor frequency to the transmitter coils 107. The Larmor frequency is defined by a type of target atoms and a magnetic field strength.

The receiver coil 109 is located inside the gradient coils 103, to receive magnetic resonance (MR) signals which are issued from the subject P due to an influence of the high-frequency magnetic field. The receiver coil 109 outputs the MR signals to the receiver circuitry 110 upon receipt.

The transmitter coils 107 and the receiver coil 109 as described above are presented for illustrative purpose only. Each of the transmitter coils 107 and the receiver coil 109 may be one or a combination of a coil having a transmission function alone, a coil having a reception function alone, and a coil having both transmission and reception functions.

The receiver circuitry 110 detects MR signals output from the receiver coil 109 and generates MR data from the detected MR signals. Specifically, the receiver circuitry 110 generates MR data by converting the MR signals output from the receiver coil 109 into digital signals. The receiver circuitry 110 transmits the MR data to the sequence control circuitry 120. The receiver circuitry 110 may be included in a gantry equipped with the static magnetic field magnets 101, the gradient coils 103, and other elements.

The sequence control circuitry 120 performs imaging of the subject P by driving the gradient field power supply 104, the transmitter circuitry 108, and the receiver circuitry 110 based on sequence information transmitted from the computer 130. Herein, the sequence information represents information including defined imaging procedures and may be simply referred to as a sequence. The sequence information includes definitions of current intensity and current supply timing from the gradient field power supply 104 to the gradient coils 103, RF pulse intensity and RF pulse application timing from the transmitter circuitry 108 to the transmitter coils 107, and MR-signal detection timing by the receiver circuitry 110, for example.

Examples of the sequence control circuitry 120 include integrated circuitry such as an application specific integrated circuit (ASIC) and a field programmable gate array (FPGA), and electronic circuitry such as a central processing unit (CPU) and a micro processing unit (MPU). The sequence control circuitry 120 corresponds to a sequence control unit.

After the subject P has been imaged as a result of driving the gradient field power supply 104, the transmitter circuitry 108, and the receiver circuitry 110, the sequence control circuitry 120 receives MR data from the receiver circuitry 110 and transfers the MR data to the computer 130.

The functions of the sequence control circuitry 120 are now explained. The sequence control circuitry 120 includes a prepulse application function 121, a readout function 122, a main-acquisition function 123, and an output function 124. Processing and functions to be performed by the prepulse application function 121, the readout function 122, the main-acquisition function 123, and the output function 124 are stored in the memory mounted on the sequence control circuitry 120 in the form of computer program executable by the sequence control circuitry 120. The sequence control circuitry 120 is a processor that retrieves and executes the computer programs from the memory to implement the functions corresponding to the respective computer programs. In other words, having retrieved the computer programs, the sequence control circuitry 120 includes the respective functions shown in the sequence control circuitry 120 of FIG. 1.

FIG. 1 depicts an example that the single piece of sequence control circuitry 120 implements the processing and functions of the prepulse application function 121, the readout function 122, the main-acquisition function 123, and the output function 124. Alternatively, the sequence control circuitry 120 may be constituted of a combination of independent processors so that the processors can individually implement the functions by executing the computer programs. In other words, the above functions may be configured as individual computer programs to be executed by the single piece of sequence control circuitry 120, or particular function or functions may be incorporated in dedicated, independent program-executable circuitry.

The term "processor" used herein signifies, for example, circuitry such as a CPU, an application specific integrated circuit, and a programmable logic device (e.g., a simple programmable logic device (SPLD), a complex programmable logic device (CPLD), and a field programmable gate array (FPGA)). The processor retrieves and executes the computer programs from the memory to implement the functions.

In addition, in place of being stored in the memory, the computer programs may be directly embedded in the circuitry of the processor. In such a case the processor retrieves and executes the computer programs from the circuitry to implement the functions. Likewise, the couch control circuitry 106, the transmitter circuitry 108, the receiver circuitry 110, and processing circuitry 150 as described later each include electronic circuitry such as the above processor.

The sequence control circuitry 120 uses the prepulse application function 121 to irradiate the subject P with saturation RF pulses (which may also be referred to as saturation prepulses) as prepulses. Specifically, the prepulse application function 121 applies saturation RF pulses to the subject P via the transmitter circuitry 108 and the transmitter coils 107. Alternatively, the prepulse application function 121 may control the gradient field power supply 104 to apply a slice-select magnetic field to the subject P along with the irradiation of the saturation RF pulse. The sequence control circuitry 120 implementing the prepulse application function 121 corresponds to a prepulse application unit.

The following will describe differences between a saturation RF pulse and an excitation RF pulse. The excitation RF pulse refers to an excitation RF pulse for data acquisition, for example. The saturation RF pulse is to be applied at a different time from the excitation RF pulse. In addition, the saturation RF pulses are often RF pulses which ignore consistency of phases, unlike the excitation RF pulses. As such, the saturation RF pulse and the excitation RF pulse are different RF pulses, differing in irradiation time or timing.

Specifically, the saturation RF pulses are emitted to the subject P before application of a main acquisition sequence including an excitation RF pulse. The saturation RF pulses correspond to, for example, non-slice selective, chemical shift selective (CHESS) pulses (e.g., water-suppression pulse, fat-suppression pulse). The saturation RF pulses are predetermined in accordance with MR-signal acquisition timings set in the main acquisition sequence. For example, a saturation-RF-pulse band and a slice-select strength to be applied along with a saturation RF pulse are required to satisfy an imposed condition according to the purpose of the main acquisition sequence.

Meanwhile, the band and slice-select strength of navigation RF pulses for use in navigator acquisition can be suitably designed in conformity with the purpose of the navigator acquisition. As such, it can be said that the saturation RF pulses and the navigation RF pulses are mutually different RF pulses in terms of their purpose and design concept.

The sequence control circuitry 120 uses the readout function 122 to read out saturation magnetic resonance signals in a spatially selective manner. The saturation magnetic resonance signals correspond to signals excited by the saturation RF pulses. The expression "spatially selective" refers to application of a readout gradient field, for example. Further, the signals excited by the saturation RF pulses correspond to MR signals issued from the subject P when irradiated with the saturation RF pulses. Thus, the saturation RF pulses are used for suppressing water or fat MR signals, however, they also excite the substance to be suppressed to cause MR signals (saturation MR signals). In other words, the saturation RF pulse serves as a type of excitation while the saturation MR signal contains information necessary for the calibration or correction of main-acquisition data, for instance. In this regard, the saturation MR signal may be referred to as saturation-RF-pulse information.

Spoilers are applied to the subject P after the irradiation of saturation RF pulses and before execution of the main acquisition sequence. The readout function 122 utilizes such spoilers to read out saturation MR signals. The spoilers can be, for example, gradient spoilers or RF spoilers. In the following, spoilers are defined as gradient spoilers for the sake of simpler explanation. The irradiation of saturation RF pulses and the saturation-MR-signal readout are included in a pre-acquisition to be performed before the main acquisition sequence. The pre-acquisition includes application of a spoiler gradient (also referred to as a gradient spoiler) that causes dephasing of saturation MR signals. Such a spoiler gradient includes a readout gradient field for saturation-MR-signal readout.

Specifically, the readout function 122 controls the gradient field power supply 104 after the irradiation of saturation RF pulses to apply a spoiler gradient to the subject P. The readout function 122 then reads out saturation MR signals via the receiver coil 109 and the receiver circuitry 110. The saturation MR signal can be referred to as saturation MR data since it is digitized by the receiver circuitry 110.

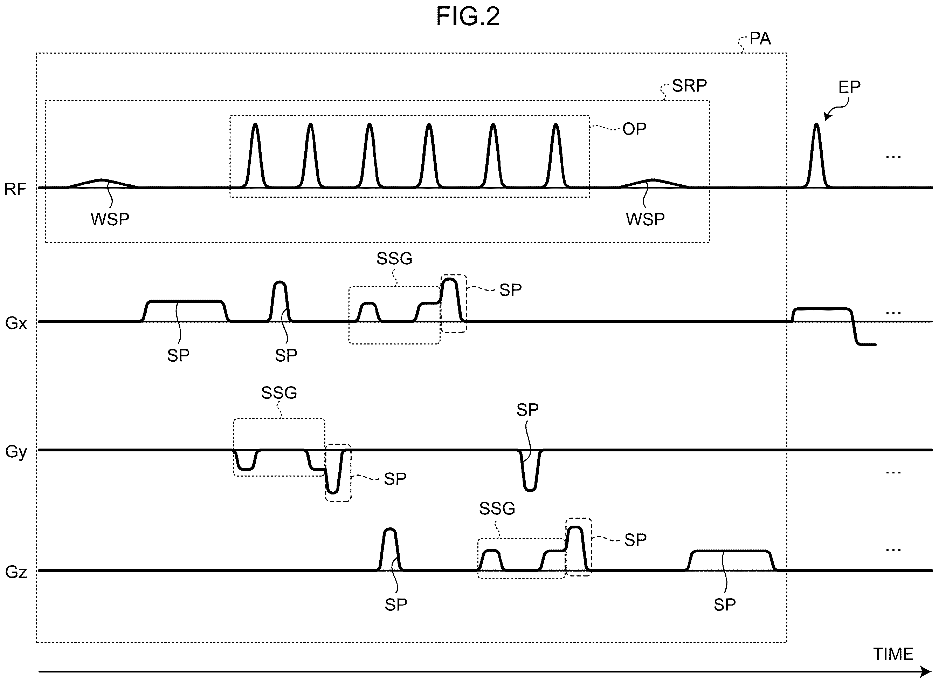

FIG. 2 depicts an example of a pre-acquisition sequence PA. In FIG. 2 the pre-acquisition sequence PA includes multiple saturation RF pulses SRP, gradient spoilers SP related to saturation-MR-signal readout and spoilers, and slice-select gradient fields SSG. As an example, the saturation RF pulses SRP include two water suppression pulses WSP and six OVS pulses OP, as depicted in FIG. 2. In the example of FIG. 2, the readout function 122 reads out the saturation MR signals responsive to the two water suppression pulses WSP and the six OVS pulses OP, using the gradient spoilers SP.

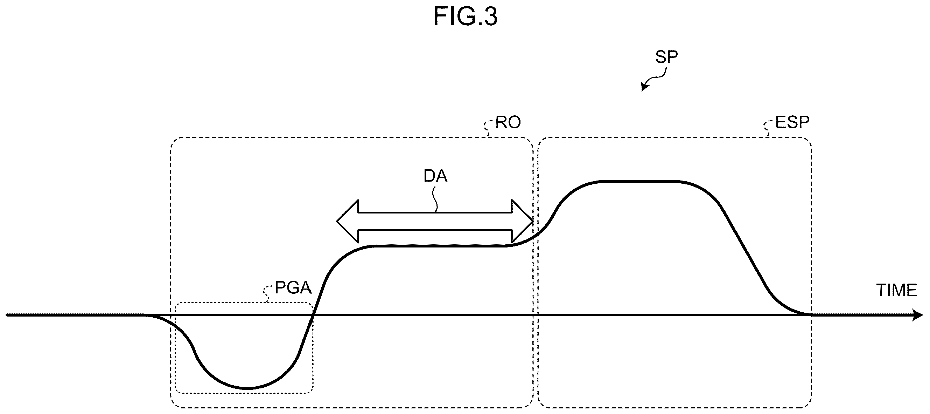

FIG. 3 depicts an example of a gradient spoiler SP related to a saturation-MR-signal readout. As depicted in FIG. 3, the gradient spoiler SP includes a readout gradient field RO and an end spoiler ESP. The end spoiler ESP is a gradient field that spoils the saturation MR signals after application of the readout gradient field RO. In the readout gradient field RO of FIG. 3, the bi-directional arrow DA indicates a readout period for the saturation MR signals. As depicted in FIG. 3, the readout gradient field RO includes a gradient field (hereinafter, referred to as an adjustive gradient field) PGA for adjusting a readout start position of the saturation MR signals. The application period of the adjustive gradient field PGA corresponds to a duration during which the readout start position of the saturation MR signals can be set at an end of k-space, for example.

In the example of FIG. 3, when the time interval between one saturation RF pulse and the next saturation RF pulse and the time interval between the last one of the saturation RF pulses and the excitation RF pulse are both longer than the application period of the adjustive gradient field PGA, the adjustive gradient field PGA is set in the pre-acquisition sequence PA. The adjustive gradient field PGA and the gradient spoiler SP of FIG. 3 are set by the setting function 134 as described later.

In addition, in FIG. 2 the water suppression pulses WSP emitted to the subject P are non-slice selective, for example. The OVS pulses OP in FIG. 2 are emitted to the subject P along with the slice-select gradient field SSG. In this case, in k-space the saturation-MR-signal readout line by each of the saturation RF pulses SRP will be a single line on the space, starting from an end of the k-space as the readout start position of saturation MR signals.

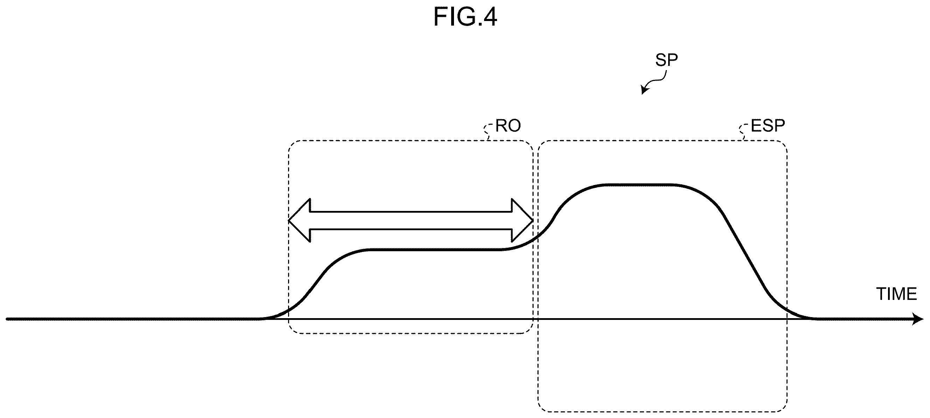

FIG. 4 depicts another example of the gradient spoiler SP different from the one in FIG. 3. As depicted in FIG. 4, the readout gradient field RO includes no adjustive gradient field PGA, unlike that in FIG. 3. FIG. 4 shows one example of the gradient spoiler SP when the time interval between one saturation RF pulse and the next saturation RF pulse and the time interval between the last one of the saturation RF pulses and the excitation RF pulse are both shorter than the application period of the adjustive gradient field PGA.

The gradient spoiler SP in FIG. 4 is set by the setting function 134 as described later. In this case, in k-space the saturation-MR-signal readout line by each of the saturation RF pulses SRP will be a single line on the space, starting from the center of the k-space as the readout start position of saturation MR signals. In other words, the saturation-MR-signal readout line corresponds to one example of half scan.

Alternatively, the readout function 122 may read out saturation MR signals along multi-dimensional readout lines, such as echo planar imaging (EPI) or spiral scan. The gradient spoiler SP that implements the multi-dimensional readout lines is set by the setting function 134 as described later. In this case, the set readout gradient field includes a multi-dimensional readout gradient field.

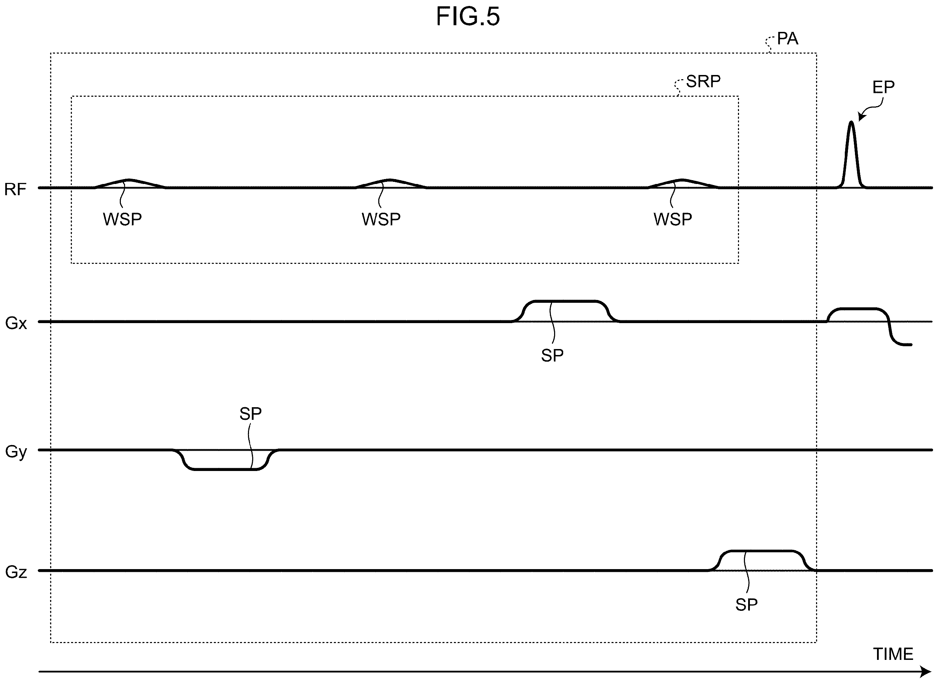

FIG. 5 depicts an example of the pre-acquisition sequence PA including saturation RF pulses SRP. As depicted in FIG. 5, the saturation RF pulses SRP include three water suppression pulses WSP. The pre-acquisition sequence PA of FIG. 5 is for use in water suppression intended for MRS, such as water suppression enhanced through T1 effects (WET) or VAriable Power and Optimized Relaxation delays (VAPOR).

As depicted in FIG. 5, the gradient spoilers SP for the three water suppression pulses WSP are applied along the three axes (Gx, Gy, Gz). However, the three-axial gradient spoilers SP in FIG. 5 are not to be regarded as limiting. For example, the gradient spoiler SP may be additionally applied in an oblique direction as an X-Y direction. The gradient spoilers SP then implement multi-dimensional readout lines such as (kx·ky) directions, in addition to the three axes on k-space, i.e., kx, ky, and kz directions. Further, the gradient spoilers SP may cause a change of the saturation-MR-signal readout lines in units of TR between the saturation RF pulses.

Moreover, the readout function 122 may read out saturation-RF-pulse information by using a readout gradient field with frequencies set or adjusted in line with a chemical shift. The frequencies of the readout gradient field are set or adjusted in line with a chemical shift by the setting function 134 as described later. A set readout gradient field includes a multi-dimensional readout gradient field. The sequence control circuitry 120 implementing the readout function 122 corresponds to a readout unit.

The sequence control circuitry 120 uses the main-acquisition function 123 to perform a main acquisition after the irradiation of the saturation RF pulses. The main acquisition includes irradiation of an excitation RF pulse EP (FIG. 2) being different from the saturation RF pulses. In accordance with the main acquisition sequence, the main-acquisition function 123 applies the excitation RF pulse EP to the subject P via the transmitter circuitry 108 and the transmitter coils 107, for example.

Next, the main-acquisition function 123 controls the gradient field power supply 104 to apply the various kinds of gradient fields to the subject P, following the main acquisition sequence. The main-acquisition function 123 also acquires MR signals by a main acquisition via the receiver coil 109 and the receiver circuitry 110. The MR signals acquired by the main acquisition are converted to MR data through the receiver circuitry 110. Hereinafter, the MR data acquired by the main acquisition will be referred to as main-acquisition data. The sequence control circuitry 120 implementing the main-acquisition function 123 corresponds to a main acquisition unit.

The sequence control circuitry 120 uses the output function 124 to output the main-acquisition data and the saturation MR signals. For example, the output function 124 outputs the main-acquisition data and the saturation MR signals to the computer 130. Specifically, the output function 124 outputs the main-acquisition data and the saturation MR signals to the processing circuitry 150. Alternatively, the output function 124 may output the main-acquisition data and the saturation MR signals to a memory circuitry 132. The sequence control circuitry 120 implementing the output function 124 corresponds to an output unit.

The computer 130 performs overall control of the MRI apparatus 100 and generates images, for example. The computer 130 includes the memory circuitry 132, an input apparatus 141, a display 143, and the processing circuitry 150. The processing circuitry 150 includes an interface function 131, a control function 133, the setting function 134, an image generation function 136, an inferring function 138, and a correction function 139.

The memory circuitry 132 stores therein various kinds of MR data (e.g., main-acquisition data and saturation MR signals) as received by the interface function 131 of the processing circuitry 150 and various kinds of image data generated by the image generation function 136, for example. The memory circuitry 132 further stores MR data arranged by the control function 133 in k-space (also referred to as k-space data). The memory circuitry 132 can be implemented by, for example, a semiconductor memory device such as random access memory (RAM) or flash memory, a hard disk, or an optical disk. The memory circuitry 132 may be referred to as memory.

The input apparatus 141 receives various kinds of instructions and information inputs from the user. Examples of the input apparatus 141 include a trackball, a switch button, a mouse, a keyboard, a touchpad that allows input by touch on the operation surface, a touch screen as an integration of a display screen and a touchpad, a non-contact input circuit including an optical sensor, and a voice input circuit. The input apparatus 141 is electrically connected to the processing circuitry 150 to convert user inputs into electrical signals and outputs them to the processing circuitry 150. The input apparatus 141 corresponds to an input unit.

In this disclosure, the input apparatus 141 is not limited to the one including physical operational component or components (input interface) as a mouse and a keyboard. Other examples of the input apparatus 141 include electrical-signal processing circuitry that receives an electrical signal corresponding to an input from an external input apparatus separated from the MRI apparatus 100 to output the electrical signal to control circuitry. The input apparatus 141 corresponds to an input unit and may be referred to as an input interface or an operational unit.

Under the control of the control function 133 of the processing circuitry 150, the display 143 displays a graphical user interface (GUI) to allow the user to input imaging conditions and else as well as displays images generated by the image generation function 136 of the processing circuitry 150. Examples of the display 143 include a cathode ray tube (CRT) display, a liquid crystal display (LCD), an organic electroluminescence display (OELD), a light-emitting diode (LED) display, a plasma display, any of other displays known in related art, and a display device as a monitor. The display 143 corresponds to a display unit.

Processing and functions to be performed by the interface function 131, the control function 133, the setting function 134, the image generation function 136, the inferring function 138, and the correction function 139 are stored in the memory circuitry 132 in the form of computer program executable by the computer 130. The processing circuitry 150 is a processor that retrieves and executes the computer programs from the memory circuitry 132 to implement the functions corresponding to the respective computer programs. In other words, having retrieved the computer programs, the processing circuitry 150 includes the respective functions shown within the processing circuitry 150 of FIG. 1.

FIG. 1 depicts an example that the single piece of processing circuitry 150 implements the processing and functions of the interface function 131, the control function 133, the setting function 134, the image generation function 136, the inferring function 138, and the correction function 139. Alternatively, the processing circuitry 150 may be constituted of a combination of independent processors so that the processors can individually implement the functions by executing the computer programs. In other words, the above functions may be configured as individual computer programs to be executed by the single piece of processing circuitry 150, or particular function or functions may be incorporated in dedicated, independent program-executable circuitry.

The term "processor" used herein signifies, for example, circuitry such as a CPU, a GPU, an application specific integrated circuit, and a programmable logic device (e.g., simple programmable logic device (SPLD), a complex programmable logic device (CPLD), and a field programmable gate array (FPGA)). The processor retrieves and executes the computer programs from the memory circuitry 132 to implement the functions.

In place of being stored in the memory circuitry 132, the computer programs may be directly embedded in the circuitry of the processor. In such a case the processor retrieves and executes the computer programs from the circuitry to implement the functions. Likewise, the couch control circuitry 106, the transmitter circuitry 108, the receiver circuitry 110, and the sequence control circuitry 120 each include electronic circuitry such as the above processor.

The processing circuitry 150 uses the interface function 131 to transmit sequence information to the sequence control circuitry 120 and receive MR data from the sequence control circuitry 120. The interface function 131 stores the MR data in the memory circuitry 132 upon receipt. For example, the interface function 131 receives main-acquisition data and saturation MR signals from the output function 124. The interface function 131 outputs the main-acquisition data and the saturation MR signals to the memory circuitry 132 or the respective functions of the processing circuitry 150 upon receipt. The processing circuitry 150 implementing the interface function 131 corresponds to an interface unit.

The processing circuitry 150 uses the control function 133 to perform overall control of the MRI apparatus 100 to control imaging, image generation, image display, and else. As an example, the control function 133 receives an input of an imaging condition (e.g., imaging parameters) via the GUI to generate sequence information according to the input imaging condition. The processing circuitry 150 including the control function 133 transmits the generated sequence information to the sequence control circuitry 120. The processing circuitry 150 implementing the control function 133 corresponds to a control unit.

The processing circuitry 150 uses the setting function 134 to set or adjust spoiler timing or spoiler strength in relation to the saturation-MR-signal readout. For example, the setting function 134 determines whether or not to be able to set an adjustive gradient field in an unset pre-acquisition sequence PA. Specifically, the setting function 134 compares each of the time interval between a saturation RF pulse and the next saturation RF pulse and the time interval between the last one of the saturation RF pulses and the excitation RF pulse with a predetermined threshold. Examples of the predetermined threshold include a duration of application of the gradient spoiler SP (a sum of an application duration of the readout gradient field RO and an application duration of the end spoiler ESP).

When the time interval between the saturation RF pulse and the next saturation RF pulse and the time interval between the last one of the saturation RF pulses and the excitation RF pulse both exceed the predetermined threshold, the setting function 134 sets the readout gradient field RO including the adjustive gradient field PGA in the gradient spoiler SP, as depicted in FIG. 3. When the time interval between the saturation RF pulse and the next saturation RF pulse and the time interval between the last saturation RF pulse and the excitation RF pulse are both equal to or less than the predetermined threshold, the setting function 134 sets the readout gradient field RO including no adjustive gradient field PGA in the gradient spoiler SP, as depicted in FIG. 4.

Further, the setting function 134 sets the spoiler gradient in such a manner that an integral of the spoiler gradient during the spoiler-gradient application duration matches a design value defined according to the main acquisition sequence. For example, with respect to the gradient spoiler SP including the adjustive gradient field PGA in FIG. 3, the setting function 134 sets the gradient strength of the end spoiler ESP immediately after the readout gradient field RO to an increased value, so as to offset a negative part of the adjustive gradient field PGA and compensate for a decrease in the gradient strength due to the readout gradient field RO.

With respect to the gradient spoiler SP including no adjustive gradient field PGA in FIG. 4, the setting function 134 sets the gradient strength of the end spoiler ESP immediately after the readout gradient field RO to an increased value, so as to compensate for a decrease in the gradient strength due to the readout gradient field RO. In this manner, the setting function 134 sets the gradient strength of the end spoiler ESP immediately after the readout gradient field RO to an increased value matching the design value.

Further, the setting function 134 sets or adjusts the frequencies of the readout gradient field RO in line with a chemical shift. In fat suppression, for example, MR signals arising from fat are suppressed by a fat suppression pulse on the premise of the chemical shift of fat. The chemical shift of fat is defined as 3.5 ppm so that the center frequency of the saturation RF pulse is offset by 3.5 ppm. To match the center frequency of the readout gradient field RO with the center frequency of the saturation RF pulse, the setting function 134 shifts the center frequency of the readout gradient field RO by, for instance, 3.5 ppm, to match that of the saturation RF pulse.

In addition, the setting function 134 may set the application timing of the excitation RF pulse EP and the application timings of the variety of gradient fields in the main acquisition sequence, in accordance with a state of respiration of the subject P as inferred by the inferring function 138 described later. In this case the sequence control circuitry 120 uses the main-acquisition function 123 to perform the main acquisition sequence at the timings as set.

The setting function 134 sets a first receiver gain for the saturation-MR-signal readout and a second receiver gain for the acquisition of main-acquisition data. The first receiver gain and the second receiver gain differ from each other. For example, the first receiver gain is set larger than the second receiver gain at the time when the saturation MR signal is smaller than the MR signal for the acquisition of main-acquisition data.

As an example, while the pre-acquisition sequence PA is running, the setting function 134 sets, as the first receiver gain, the gain of the gain amplifier in a stage preceding the analog-to-digital converter (ADC) in the receiver circuitry 110. While the main acquisition sequence is running, the setting function 134 sets the gain of the gain amplifier of the receiver circuitry 110 as the second receiver gain. The processing circuitry 150 implementing the setting function 134 corresponds to a setting unit.

The processing circuitry 150 uses the image generation function 136 to generate a first magnetic resonance (MR) image by performing the one-dimensional inverse Fourier transform on saturation MR signals in the readout direction of the saturation MR signals. Thus, the image generation function 136 generates the first MR image by applying the one-dimensional inverse Fourier transform to the saturation MR signals. The first MR image corresponds to a one-dimensional image in which the pixels are aligned along the axis corresponding to the saturation-MR-signal readout direction.

As such, the information obtained from the saturation MR signals represents data resulting from multiplying an integral of a three-dimensional space by a one-dimensional modulation. As a result of applying a readout gradient field in the X-direction for readout of saturation MR signals, for example, the first MR image contains a mix of Y-directional signals and Z-directional signals. In this first MR image, X-directional pixel values are separated. The first MR image can also be a one-dimensional image of either water or fat, for instance, depending on a type of the saturation RF pulses.

The image generation function 136 generates a second magnetic resonance (MR) image by applying the inverse Fourier transform to the main-acquisition data. As for main-acquisition data arranged in a two-dimensional k-space, for example, the image generation function 136 generates a two-dimensional second MR image by applying the two-dimensional inverse Fourier transform to the main-acquisition data. Likewise, as for main-acquisition data arranged in a three-dimensional k-space, for example, the image generation function 136 generates a three-dimensional second MR image by applying the three-dimensional inverse Fourier transform to the main-acquisition data. The generation of first MR images and second MR images can be implemented by any of known methods, therefore, a description thereof is omitted. The processing circuitry 150 implementing the image generation function 136 corresponds to an image generator unit.

The processing circuitry 150 uses the inferring function 138 to infer the motion of the subject P from the first MR image. As an example, the inferring function 138 compares two or more first MR images to infer the motion of the subject P. Specifically, the inferring function 138 infers one-dimensional motion of a substance to be saturated in the readout-gradient application direction in each TR by comparing two chronologically neighboring first MR images for which readout gradients have been applied in the same direction (e.g., comparison between high-luminance regions or comparison between difference regions in inter-frame difference images). When the substance to be saturated is water and the readout-gradient application direction is the X-axis, for example, the inferring function 138 computes variations in pixel value along the X-axis to thereby determine presence or absence of the water along the X-axis and infer the motion of the water if present. In addition, the inferring function 138 can improve the accuracy in terms of motion inference by setting the readout gradient strength for the saturation MR signals to a weaker strength.

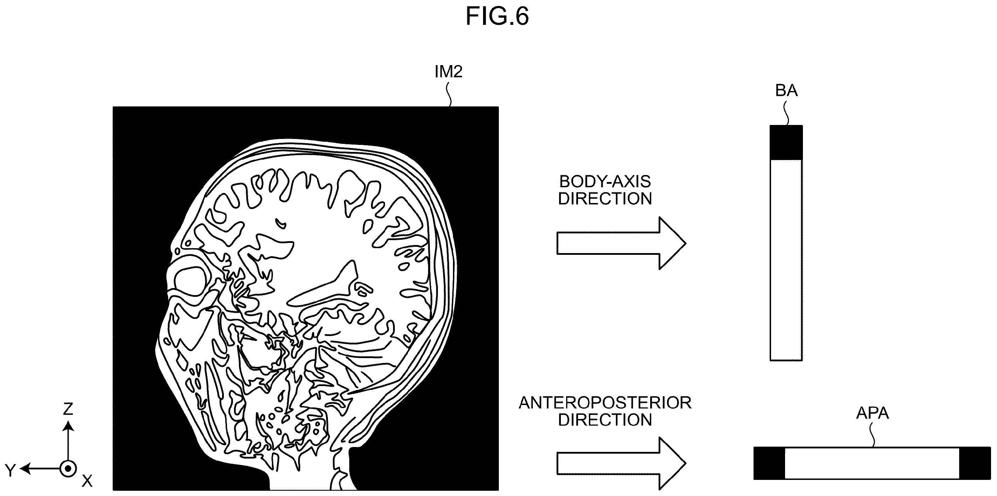

FIG. 6 depicts a second MR image IM2 of the subject P, a first MR image BA in the Z-direction (along the body axis of the subject P), and a first MR image APA in the Y-direction (anteroposterior direction of the subject P), as an example. The Z-directional first MR image BA is a one-dimensional MR image based on saturation MR signals read out with a Z-directional readout gradient field. The Y-directional first MR image APA is a one-dimensional MR image based on saturation MR signals readout with a Y-directional readout gradient field.

As depicted in FIG. 6, the first MR image shows presence or absence of signals in the direction in which the readout gradient field has been applied. The first MR image may contain aliasing depending on the application direction of the readout gradient field. However, the inferring function 138 is able to infer the motion of a substance (e.g., water or fat) depending on a type of the saturation RF pulses through comparison between two or more first MR images. This motion inference is higher in accuracy in the longitudinal direction (Z-direction).

As depicted in FIG. 5, the water-suppression saturation RF pulses intended for MRS are applied to the subject P on each of the three axes. In this case, two or more first MR images are generated using the saturation MR signals acquired on a TR basis. The inferring function 138 then infers the motion of the subject P along each of the three axes from each of the three-axial first MR images. In addition, the inferring function 138 can infer two or more dimensional motion by changing the saturation RF pulse method to another on a TR basis. The inferring function 138 may infer one-dimensional motion based on each acquired signal or infer two-dimensional motion by combining two or more pieces of projection data.

An example of the use of spatially non-selective saturation RF pulses has been described above. Alternatively, the saturation RF pulses may be read out using spatially selective saturation RF pulses. For example, the selective saturation RF pulses can be the OVS pulses OP or sat band pulses as shown in FIG. 2. In this example, as the saturation-MR-signal readout, the setting function 134 sets two axes of a selective readout to limit a saturation region and a selective saturation band. Because of the saturation RF pulses being spatially selective, phase shifts may be noticeably superimposed on the saturation MR signals. Thus, the use of saturation RF pulses with no phase shifts is preferable. For example, either the real part or the imaginary part of the saturation RF pulse may be modified.

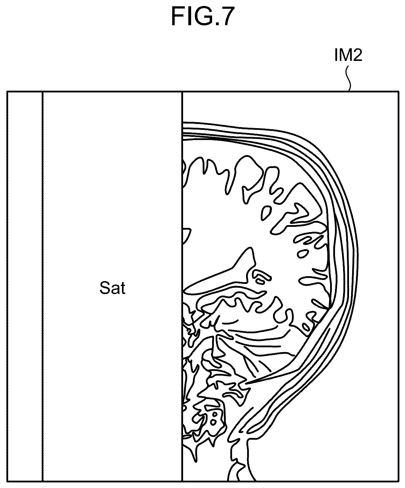

FIG. 7 depicts a limited saturation region Sat of saturation RF pulses and the second MR image IM2 of the subject P, by way of example. As depicted in FIG. 7, the behavior of the saturation MR signals will change depending on a selection of the readout directions, which will also change the inference of motion of the subject P. For example, the inferring function 138 can infer a displacement (motion) of a region within the region Sat of FIG. 7 where selective saturation RF pulses are applied (in the direction of sat band). Also, the inferring function 138 can infer a displacement (motion) of the subject P across the entire image outside the region Sat of FIG. 7.

Moreover, the inferring function 138 infers a respiratory state of the subject P from the first MR images. When the saturation RF pulses are fat suppression pulses and the object being imaged is the liver, for example, the inferring function 138 detects the motion of the liver based on the first MR images. Specifically, with respect to multiple saturation MR signals acquired prior to execution of the main acquisition sequence, the inferring function 138 infers the motion of the liver from changes in two of the first MR images, the two first MR images being temporally neighboring and for which the readout gradients for the saturation MR signals have been applied in the same direction.

As an example, if the object being imaged is a fatty organ, the motion of the organ will appear as variations in pixel value on two first MR images, the variations representing a relationship of pixel intensities on the first MR images. The inferring function 138 thus infers or analogizes the respiratory state of the subject P from the detection of the liver's motion. Any of known methods can be adopted for the respiratory-state inferring method based on the motion of the object being imaged, therefore, a description thereof is omitted.

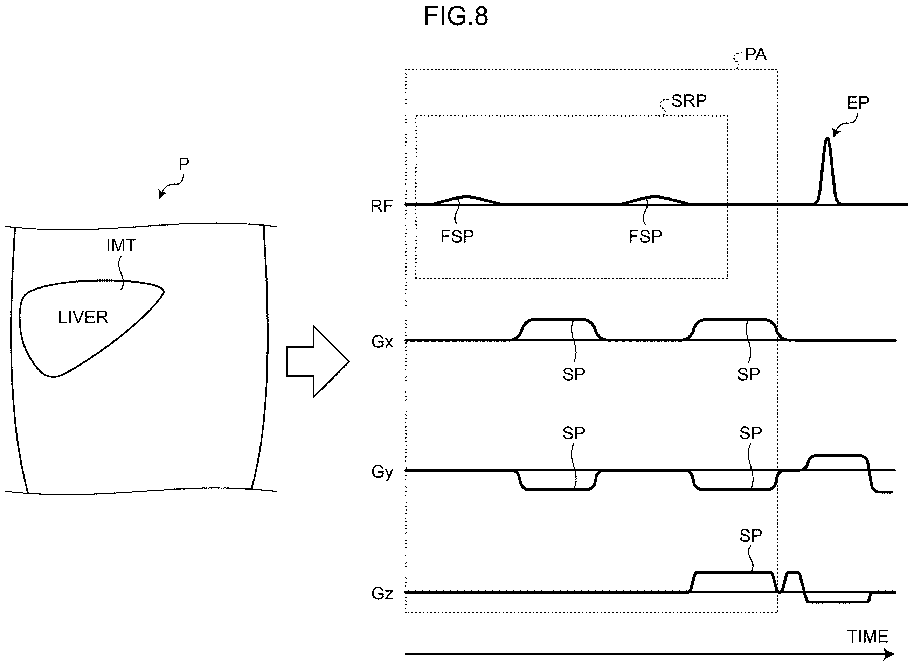

FIG. 8 depicts an example of the pre-acquisition sequence PA when the object being imaged is the liver. As depicted in FIG. 8, the multiple saturation RF pulses SRP include two fat suppression pulses FSP. In this example, the inferring function 138 detects the motion of the object being imaged IMT, i.e., the liver of the subject P, from two first MR images corresponding to two saturation MR signals acquired by multiple spoilers SP responsive to the two fat suppression pulses FSP.

The inferring function 138 then infers the respiratory state of the subject P based on the liver's motion. Then, the setting function 134 sets the variety of timings in the main acquisition sequence, in accordance with the inference of the respiratory state of the subject P. Next, the sequence control circuitry 120 uses the main-acquisition function 123 to perform the main acquisition sequence at the set timings. In this manner, the main-acquisition function 123 performs a main acquisition in synchronization with the respiration of the subject P, based on the inference of the respiratory state of the subject P. Namely, the main-acquisition function 123 utilizes the saturation MR signals as a navigator for respiratory-gated scanning.

There may be a situation that the motion of the object being imaged does not suitably appear as variations in pixel value on two first MR images, depending on the pre-acquisition sequence PA. In such a case, for example, immediately before the pre-acquisition sequence PA, the sequence control circuitry 120 may additionally perform a calibration scan (e.g., the main acquisition is defined as two-dimensional cine imaging in the body long-axis direction) that can easily capture the respiratory state of the subject P. The inferring function 138 then computes or determines the associations between the respiratory state of the subject P and MR images based on the signals acquired by the calibration scan. The inferring function 138 then performs matching between the first MR images and a list containing the associations to infer the respiratory state of the subject P.

The above example has described the inference of the respiratory state through the matching with the list, however, the inference of the respiratory state is not limited to such an example. As an example, the inferring function 138 may input the first MR images to a trained model, having learned to receive an input of the first MR images to output a respiratory state, and infer the respiratory state of the subject P from an output of the trained model. The processing circuitry 150 implementing the inferring function 138 corresponds to an inferring unit.

The processing circuitry 150 uses the correction function 139 to perform a motion correction to the second MR image based on the inference of the motion. Namely, the correction function 139 corrects the motion of the subject P on the second MR image according to differences in pixel value of multiple first MR images corresponding to multiple saturation MR signals. Any of known methods is applicable to the motion correction of the second MR image by the correction function 139, therefore, a description thereof is omitted. The processing circuitry 150 implementing the correction function 139 corresponds to a corrector unit.

The overall structure and configuration of the MRI apparatus 100 of some embodiments have been described above. Having such structure and configuration, the MRI apparatus 100 of some embodiments reads out saturation MR signals in a spatially selective manner by application of saturation RF pulses, to perform a process for utilizing the saturation MR signals (hereinafter, a saturation-MR-signal utilization process). Examples of the saturation-MR-signal utilization process include the use of saturation MR signals for the motion correction to the second MR image or for the above-described navigator. The following will explain the motion correction of the second MR image as an example of the saturation-MR-signal utilization process.

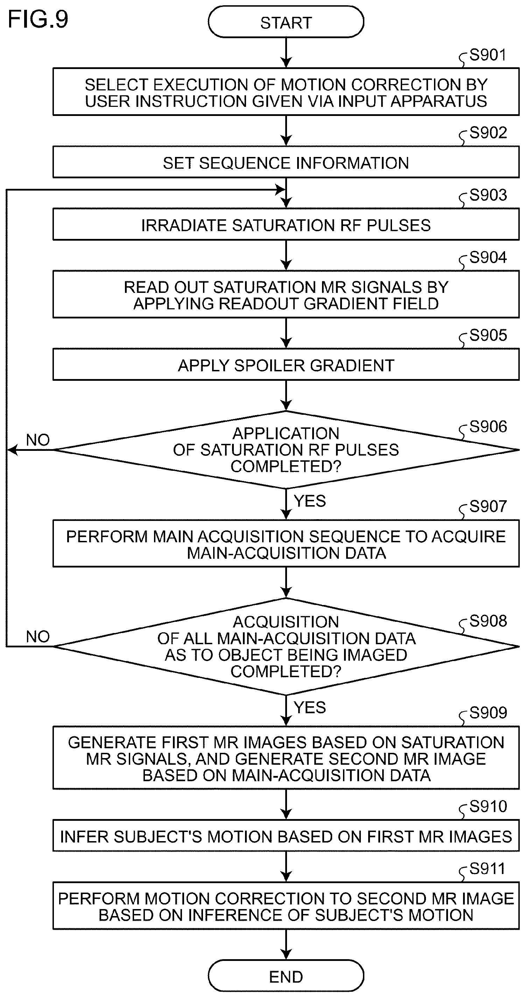

The steps of the saturation-MR-signal utilization process will be described with reference to FIG. 9. FIG. 9 is a flowchart illustrating exemplary steps of the saturation-MR-signal utilization process.

### Saturation MR-signal Utilization Process

### Step S901

Prior to the use of the saturation MR signals, the display 143 displays a selection screen that allows a selection of usage of the saturation MR signals. For example, the display 143 displays execution or non-execution of the motion correction and/or selection or non-selection of the navigator on the selection screen as options for the usage of the saturation MR signals. Specifically, the processing circuitry 150 causes the display 143 to display the selection screen prior to running the pre-acquisition sequence PA and the main acquisition sequence. The execution of the motion correction is then selected by a user instruction given via the input apparatus 141.

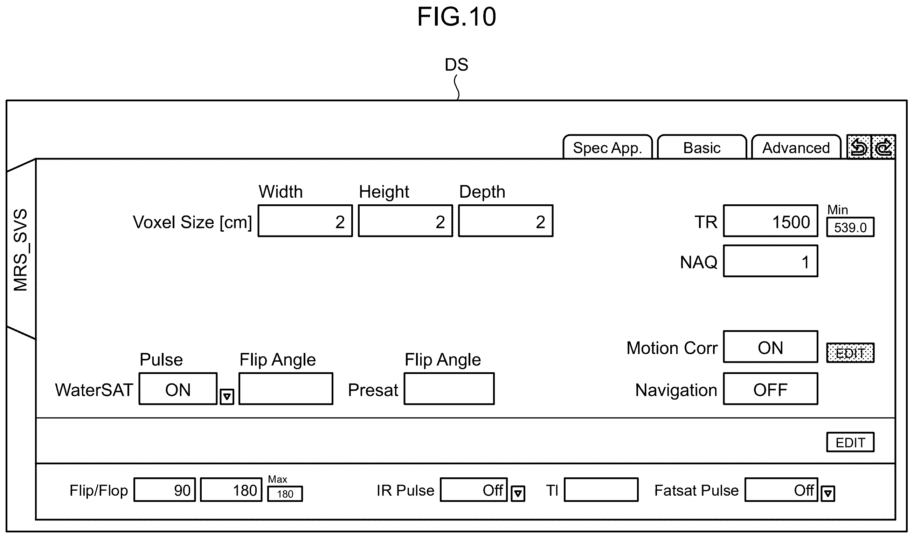

FIG. 10 depicts an example of a selection screen DS. In FIG. 10, as a result of a user selection, the motion correction button (Motion Corr) and the water saturation button (WaterSAT) are ON and the navigation button (Navigation) is OFF on the selection screen DS. Alternatively, the user may set other items including the flip angle of the saturation RF pulse. For another example, to perform a main acquisition sequence involving a respiratory synchronization, the user selectively turns on the navigation button (Navigation) and the water saturation button (WaterSAT) and turns off the motion correction button (Motion Corr) on the selection screen DS.

### Step S902

The processing circuitry 150 uses the setting function 134 to set sequence information. The setting function 134 sets, for example, a variety of imaging parameters for the pre-acquisition sequence PA and a variety of imaging parameters for the main acquisition sequence as the sequence information. Examples of the imaging parameters for the pre-acquisition sequence PA include parameters for the readout gradient field RO (e.g., strength, application timing, application duration, and frequency of the readout gradient field RO), parameters for the end spoiler ESP (e.g., strength, application timing, and application duration of the end spoiler ESP), the first receiver gain, and parameters for saturation RF pulses (e.g., strength, flip angle, and irradiation timing of the saturation RF pulses).

Examples of the imaging parameters for the main acquisition sequence include a variety of gradient field parameters (e.g., strengths, application timings, application durations, and frequencies of the slice gradient field Gs, phase-encoding gradient field Ge, and readout gradient field Gr), the second receiver gain, and parameters for the excitation RF pulse (e.g., strength, flip angle, and irradiation timing of the excitation RF pulse).

As an example, the setting function 134 sets the various parameters for the main acquisition sequence according to a user instruction given via the input apparatus 141. In addition, the setting function 134 sets the various parameters for the pre-acquisition sequence according to selected values on the selection screen DS of FIG. 10 and according to a user instruction given via the input apparatus 141. The setting function 134 stores the set parameters in the memory circuitry 132.

### Step S903

The sequence control circuitry 120 uses the prepulse application function 121 to irradiate the subject P with saturation RF pulses. For example, the prepulse application function 121 irradiates the subject P with saturation RF pulses in accordance with the imaging parameters for the pre-acquisition sequence (i.e., saturation-RF-pulse parameters).

### Step S904

The sequence control circuitry 120 uses the readout function 122 to spatially selectively read out saturation MR signals by applying the readout gradient field RO. For example, the readout function 122 applies the readout gradient field RO to the subject P, following the imaging parameters for the pre-acquisition sequence (i.e., readout-gradient-field parameters). In this manner the readout function 122 reads out the saturation MR signals. The sequence control circuitry 120 then uses the output function 124 to output the saturation MR signals to the computer 130.

### Step S905

The sequence control circuitry 120 uses the readout function 122 to apply the end spoiler ESP. For example, the readout function 122 applies the end spoiler ESP to the subject P in accordance with the imaging parameters for the pre-acquisition sequence (i.e., parameters for the end spoiler ESP).

### Step S906

Upon completion of the application of the saturation RF pulses in the pre-acquisition sequence PA (Yes at step S906), the flow proceeds to step S907. If the application of the saturation RF pulses in the pre-acquisition sequence PA is not completed (No at step S906), the flow returns to step S903 and proceeds.

### Step S907

The sequence control circuitry 120 uses the main-acquisition function 123 to perform a main acquisition sequence to acquire main-acquisition data. For example, the main-acquisition function 123 performs a main acquisition with respect to the subject P according to the imaging parameters for the main acquisition sequence. In this manner the main-acquisition function 123 obtains the main-acquisition data. The sequence control circuitry 120 then uses the output function 124 to output the main-acquisition data to the computer 130.

### Step S908

When the acquisition of all the main-acquisition data as to the object being imaged is completed (Yes at step S908), the flow proceeds to step S909. When the acquisition of all the main-acquisition data as to the object being imaged is not completed (No at step S908), the processing at step S903 and the subsequent steps is iterated.

### Step S909

The processing circuitry 150 uses the image generation function 136 to generate first MR images based on the saturation MR signals. The image generation function 136 also generates a second MR image based on the main-acquisition data. The image generation function 136 then stores the first MR images and the second MR image in the memory circuitry 132.

### Step S910

The processing circuitry 150 uses the inferring function 138 to infer the motion of the subject P with reference to the first MR images. Specifically, the inferring function 138 infers the motion of the subject P from two chronologically neighboring first MR images for which the readout gradient fields RO have been applied in the same direction, that is, two first MR images corresponding to two neighboring frames. The inference of the subject P's motion corresponds to, for example, the number of pixels in the application direction of the readout gradient field RO. The inferring function 138 stores the inference of the subject P's motion in the memory circuitry 132.

### Step S911

The processing circuitry 150 uses the correction function 139 to perform a motion correction to the second MR image based on the inference of the subject P's motion. Specifically, the correction function 139 corrects the motion of the subject P on the second MR image with reference to the inference of the subject P's motion. The correction function 139 stores the second MR image having undergone the motion correction in the memory circuitry 132.

As described above, the MRI apparatus 100 of one embodiment performs irradiation of saturation RF pulses SRP as prepulses; reads out saturation magnetic resonance signals in a spatially selective manner, the saturation magnetic resonance signals corresponding to signals excited by the saturation RF pulses SRP; performs a main acquisition including irradiation of an excitation RF pulse EP, after the irradiation of the saturation RF pulses, the excitation RF pulse being a different RF pulse from the saturation RF pulses SRP; and outputs the saturation MR signals and main-acquisition data acquired by the main acquisition. In addition, the MRI apparatus 100 of one embodiment displays a selection screen that allows a selection of usage of the saturation MR signals on the display 143. The MRI apparatus 100 of one embodiment also displays selection or non-selection of the navigator on the selection screen as an option for the usage.

For example, in the MRI apparatus 100 of one embodiment, the irradiation of the saturation RF pulses SRP and the readout of the saturation MR signals are included in a pre-acquisition. The pre-acquisition includes application of a spoiler gradient that dephases the saturation MR signals. The spoiler gradient includes a readout gradient field for the readout of the saturation MR signals. The MRI apparatus 100 of one embodiment sets the spoiler gradient in such a manner that an integral of the spoiler gradient during a spoiler-gradient application duration matches a design value set according to the main acquisition.

Moreover, in the MRI apparatus 100 of one embodiment, the readout gradient field RO includes either an adjustive gradient field or a multi-dimensional readout gradient field for adjustment of the readout start position of the saturation MR signals. The MRI apparatus 100 of one embodiment sets frequencies of the readout gradient field RO in accordance with a chemical shift, and reads out the saturation MR signals by using the readout gradient field RO with the set frequencies. In addition, the MRI apparatus 100 of one embodiment sets a first receiver gain for the readout of the saturation MR signals and a second receiver gain for acquisition of the main-acquisition data. The first receiver gain and the second receiver gain differ from each other.

The MRI apparatus 100 of one embodiment generates a first MR image by applying the one-dimensional inverse Fourier transform to the saturation MR signals in the readout direction of the saturation MR signals, generates a second MR image by applying the inverse Fourier transform to the main-acquisition data, infers the motion of the subject P from the first MR image, and performs a motion correction to the second MR image based on the inference of the motion of the subject P. In addition, the MRI apparatus 100 of one embodiment infers a respiratory state of the subject P from the first MR image to perform the main acquisition in synchronization with the respiration of the subject P, based on the inference of the respiratory state.

The MRI apparatus 100 of one embodiment is able to read out the saturation MR signals corresponding to signals excited by the saturation RF pulse for output. Thus, the MRI apparatus 100 of one embodiment can appropriately read out and output the saturation MR signals, which have been not read out but discarded, without affecting the main acquisition. This can implement the suitable use of the saturation MR signals containing necessary information for calibration and correction.

As an example, the MRI apparatus 100 of one embodiment can generate the first MR image based on the saturation MR signals and infer the motion of the subject P from the first MR image to perform a motion correction to the second MR image based on the main acquisition with reference to the inference of the motion of the subject P. Further, the MRI apparatus 100 of one embodiment can generate the first MR image based on the saturation MR signals and infer the respiratory state of the subject P from the first MR image to perform the respiratory-gated main acquisition using the inference of the respiratory state as a navigation.

Owing to such features, the MRI apparatus 100 of some embodiments is able to efficiently use the saturation MR signals occurring due to the saturation RF pulse without discarding them, to thereby enhance the quality of output data such as the second MR images. For example, the MRI apparatus 100 of one embodiment no longer requires various kinds of RF pulses for the motion correction and respiratory gating, resulting in reduction of the imaging time. In addition, the MRI apparatus 100 of one embodiment can alleviate the burden on the subject P by shortening the examination time and/or achieve improved examination throughput by generating MR images with less artifacts arising from the motion of the subject P.

To implement the technical idea of one embodiment by a magnetic resonance imaging method, the magnetic resonance imaging method includes performing irradiation of a saturation RF pulse as a prepulse; reading out a saturation MR signal in a spatially selective manner, the saturation MR signal corresponding to a signal excited by the saturation RF pulse; performing a main acquisition including irradiation of an excitation RF pulse, after the irradiation of the saturation RF pulse, the excitation RF pulse being a different RF pulse from the saturation RF pulse; and outputting the saturation MR signal and main-acquisition data acquired by the main acquisition. The procedure and effects of the saturation-MR-signal utilization process implemented by the magnetic resonance imaging method are the same as or similar to those of the embodiments, so that a description thereof is omitted.

To implement the technical idea of one embodiment by a magnetic resonance imaging program, the magnetic resonance imaging program causes a computer to perform irradiation of a saturation RF pulse as a prepulse; read out a saturation MR signal in a spatially selective manner, the saturation magnetic resonance signal corresponding to a signal excited by the saturation RF pulse; perform a main acquisition including irradiation of an excitation RF pulse, after the irradiation of the saturation RF pulse, the excitation RF pulse being a different RF pulse from the saturation RF pulse; and output the saturation MR signal and main-acquisition data acquired by the main acquisition.

As an example, the magnetic resonance imaging program may be installed in the computer of the MRI apparatus and loaded on the memory to be able to implement the saturation-MR-signal utilization process. In this case the magnetic resonance imaging program for causing the computer to execute the saturation-MR-signal utilization process can be stored and distributed in a storage medium such as a magnetic disk (e.g., hard disk), an optical disk (e.g., CD-ROM, DVD), or a semiconductor memory. In addition to being stored in the storage medium, the magnetic resonance imaging program can be distributed using an electric communication function such as downloading via the Internet. The procedure and effects of the saturation-MR-signal utilization process by the magnetic resonance imaging program are similar to or the same as those in the embodiments, therefore, a description thereof is omitted.

According to at least one of the embodiments as above, it is made possible to read out and output saturation magnetic resonance signals corresponding to signals excited by saturation RF pulses.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the invention as defined by the appended claims.

## Claims

1. A magnetic resonance imaging apparatus (100) comprising:
a prepulse application unit (121) configured to perform irradiation of a saturation RF pulse as a prepulse;
a readout unit (122) configured to read out a saturation magnetic resonance signal in a spatially selective manner, the saturation magnetic resonance signal corresponding to a signal excited by the saturation RF pulse;
a main-acquisition unit (123) configured to perform a main acquisition including irradiation of an excitation RF pulse, after the irradiation of the saturation RF pulse, the excitation RF pulse being a different RF pulse from the saturation RF pulse; and
an output unit (124) configured to output the saturation magnetic resonance signal and main-acquisition data acquired by the main acquisition.

2. The magnetic resonance imaging apparatus (100) according to claim 1, wherein
the irradiation of the saturation RF pulse and the readout of the saturation magnetic resonance signal are included in a pre-acquisition,
the pre-acquisition includes application of a spoiler gradient that dephases the saturation magnetic resonance signal, and
the spoiler gradient includes a readout gradient field for the readout of the saturation magnetic resonance signal, the apparatus further comprising:
a setting unit (134) configured to set the spoiler gradient in such a manner that an integral of the spoiler gradient during an application duration of the spoiler gradient matches a design value set according to the main acquisition.

3. The magnetic resonance imaging apparatus (100) according to claim 2, wherein
the readout gradient field includes either a gradient field or a multi-dimensional readout gradient field for adjustment of a readout start position of the saturation magnetic resonance signal.

4. The magnetic resonance imaging apparatus (100) according to claim 2 or 3, wherein
the setting unit (134) is further configured to set frequencies of the readout gradient field in accordance with a chemical shift, and
the readout unit (122) is further configured to read out the saturation magnetic resonance signal by using the readout gradient field with the set frequencies.

5. The magnetic resonance imaging apparatus (100) according to any one of claims 1 to 4, further comprising:
an image generator unit (136) configured to
generate a first magnetic resonance image by applying a one-dimensional inverse Fourier transform to the saturation magnetic resonance signal in a readout direction of the saturation magnetic resonance signal, and
generate a second magnetic resonance image by applying an inverse Fourier transform to the main-acquisition data;
an inferring unit (138) configured to infer motion of a subject irradiated with the saturation RF pulse from the first magnetic resonance image; and
a corrector unit (139) configured to perform a motion correction to the second magnetic resonance image based on the inference of the motion of the subject.

6. The magnetic resonance imaging apparatus (100) according to any one of claims 1 to 4, further comprising:
an image generator unit (136) configured to generate a first magnetic resonance image by applying a one-dimensional inverse Fourier transform to the saturation magnetic resonance signal in a readout direction of the saturation magnetic resonance signal; and
an inferring unit (138) configured to infer a respiratory state of the subject irradiated with saturation RF pulse from the first magnetic resonance image, wherein
the main-acquisition unit (123) is further configured to perform the main acquisition in synchronization with respiration of the subject, based on the respiratory state of the subject.

7. The magnetic resonance imaging apparatus (100) according to claim 1, further comprising:
a setting unit (134) configured to set a first receiver gain for the readout of the saturation magnetic resonance signal, and set a second receiver gain for acquisition of the main-acquisition data, wherein
the first receiver gain and the second receiver gain differ from each other.

8. The magnetic resonance imaging apparatus (100) according to any one of claims 1 to 7, further comprising:
a display unit (143) that displays a selection screen that allows a selection of usage of the saturation magnetic resonance signal.

9. The magnetic resonance imaging apparatus (100) according to claim 8, wherein
the display unit (143) displays selection or non-selection of a navigator on the selection screen as an option for the usage.

10. A magnetic resonance imaging method comprising:
performing irradiation of a saturation RF pulse as a prepulse;
reading out a saturation magnetic resonance signal in a spatially selective manner, the saturation magnetic resonance signal corresponding to a signal excited by the saturation RF pulse;
performing a main acquisition including irradiation of an excitation RF pulse, after the irradiation of the saturation RF pulse, the excitation RF pulse being a different RF pulse from the saturation RF pulse; and
outputting the saturation magnetic resonance signal and main-acquisition data acquired by the main acquisition.

11. A magnetic resonance imaging program that causes a computer to execute:
performing irradiation of a saturation RF pulse as a prepulse;
reading out a saturation magnetic resonance signal in a spatially selective manner, the saturation magnetic resonance signal corresponding to a signal excited by the saturation RF pulse;
performing a main acquisition including irradiation of an excitation RF pulse, after the irradiation of the saturation RF pulse, the excitation RF pulse being a different RF pulse from the saturation RF pulse; and
outputting the saturation magnetic resonance signal and main-acquisition data acquired by the main acquisition.
